# EUROPEAN PATENT SPECIFICATION

(11) **EP 1 580 820 B1**
(45) Date of publication and mention of the grant of the patent: **07.01.2009**
(21) Application number: 05006136.5
(22) Date of filing: 21.03.2005
(51) Int. Cl.: H01L 41/24, C04B 35/638

(54) **Method of manufacturing multilayer ceramic device**
Verfahren zur Herstellung eines keramischen Mehrschichtbauelements
Procédé de fabrication d'un dispositif céramique à multicouches

(30) Priority: 26.03.2004 JP 2004092817
(43) Date of publication of application: 28.09.2005
(73) Proprietor: TDK Corporation, Tokyo 103-8272 (JP)
(72) Inventor: Nakano, Takahiro, Tokyo 103-8272 (JP); Nanao, Masaru, Tokyo 103-8272 (JP); Sakamoto, Hideya, Tokyo 103-8272 (JP); Tsukada, Takeo, Tokyo 103-8272 (JP)
(74) Representative: Müller - Hoffmann & Partner

(56) References cited:
- WO-A-20/05034255
- US-A1- 2002 098 333
- US-B1- 6 510 040
- HIRAKATA K ET AL: "MULTILAYER CAPACITORS WITH COPPER INNER ELECTRODES" FERROELECTRICS, OVERSEAS PUBLISHERS ASSOCIATIONS, AMSTERDAM, NL, vol. 133, no. 1-4, 1992, pages 139-144, XP001010835 ISSN: 0015-0193

## Description

### BACKGROUND OF THE INVENTION

### 1. Field of the Invention

The present invention relates to a method of manufacturing a multilayer ceramic device such as a multilayer piezoelectric device in which, for example, ceramic layers and internal electrode layers are alternately stacked.

### 2. Description of the Related Art

In recent years, in the technical field of electronic components using ceramic, the number of layers in the electronic components has increased in order to meet a demand for higher performance. However, when the number of layers increases, the amount of internal electrode layers increases, so when the internal electrode layers are made of a noble metal such as palladium (Pd) or silver (Ag), their manufacturing cost increases. Therefore, the use of a lower-cost base metal such as copper has been contemplated.

In US 2002 / 0098333 A1 a method of manufacturing a multilayer ceramic device is disclosed where the electrode layers contain copper. The latter is enabled by a debindering process.

However, copper is very prone to be oxidized, so when a degreasing step for removing a binder is preformed in an oxidizing atmosphere at the time of manufacturing, copper oxide is produced, thereby the volume of the internal electrode layers expands to cause cracks in lamination. Moreover, although it can be considered that the degreasing step is performed in a reducing atmosphere so as not to oxidize copper; the binder may not be sufficiently decomposed in the reducing atmosphere, thereby carbon remains in the internal electrode layers to cause a decline in properties.

As a method of overcoming such problems, for example, the use of copper oxide instead of copper metal as the raw material of the internal electrode layers has been proposed (for example, refer to Japanese Unexamined Patent Application Publication Nos. 2003-234258 and 2003-243742). In this method, the degreasing step can be performed in an oxidizing atmosphere, so residual carbon can be preferably reduced. However, copper oxide must be reduced after the degreasing step, and at this time, the volume of the internal electrode layers is reduced to cause cracks. As another method, the use of a copper alloy for the internal electrode layers has been proposed (for example, refer to Japanese Unexamined Patent Application Publication No. Sho 62-210611). However, the copper alloy has large resistivity, and is expensive.

Therefore, a method of degreasing in a reducing atmosphere including water vapor introduced into an inert gas has been proposed (for example, refer to Japanese Unexamined Patent Application Publication Nos. Hei 4-317309 and Hei 5-90066).

Conventionally the number of layers increases mainly in multilayer ceramic capacitors; however, in recent years, it has been considered to increase the number of layers in multilayer ceramic actuators using a lead-based piezoelectric ceramic material which draw attention as electronic components of fast-response fuel injection control systems for next-generation vehicle engines. In the case of the actuators, the number of layers reach several hundreds, and large actuators with a size of approximately 10 mm × 10 mm × 40 mm (height) are required.

In a conventional method described in Japanese Unexamined Patent Application Publication No. Hei 4-317309, the oxygen partial pressure is high at a temperature ranging from 100°C to 400°C. In the case where the number of layers is large, the volume of layers expands by the oxidation of copper to cause cracks. Moreover, in a conventional method described in Japanese Unexamined Patent Application Publication No. Hei 5-90066, 0.01 ppm to 1000 ppm of hydrogen is contained in the reducing atmosphere, so when a laminate is large, and the number of layers to be degreased increases, at the early stage and the middle stage of degreasing, the oxygen partial pressure is slightly insufficient, so that residual carbon can increase in the interior of the laminate. When residual carbon increases, during firing, a reducing atmosphere partially exists in the interior of the laminate, thereby lead in the ceramic layers is reduced to form lead metal, and the lead metal reacts with copper metal in the internal electrode layers to partially have a liquid phase, thereby the lead metal in a liquid phase can be melted out. Moreover, even if the lead metal is not melted, the properties of internal ceramic layers decline due to metallization of lead, and when the multilayer device is driven, a difference in actuation displacement arises between an internal portion and a peripheral portion of the multilayer device, so that distortion by the difference may cause the breakage of the laminate.

### SUMMARY OF THE INVENTION

In view of the foregoing, it is an object of the invention to provide a method of manufacturing a multilayer ceramic device such as a multilayer piezoelectric device capable of obtaining a superior multilayer ceramic device even if the number of layers increases or even if the multilayer ceramic device is upsized.

A method of manufacturing a multilayer ceramic device according to the invention comprises the step of: degreasing a laminate by heating in which ceramic precursor layers including a raw material of a ceramic layer and internal electrode precursor layers including copper metal as a raw material of an internal electrode layer are alternately stacked, wherein an atmospheric gas including an inert gas and 7 mol% to 50 mol% of water vapor is used to perform the step in an oxygen partial pressure atmosphere according to the relation:

Kp² × 10¹⁵ ≦ p(O₂) ≦ (25331 × Kp)^{2/3} (Formula 1)

wherein p(O₂) represents an oxygen partial pressure; Kp represents the water dissociation equilibrium constant; and the pressure unit is Pa, and wherein the step is performed at 550°C to 600°C.

No hydrogen is preferably mixed with the atmospheric gas. Moreover, the oxygen partial pressure is preferably within a range shown in Formula 2 is

Kp² × 10¹⁶ ≦ p(O₂) ≦ (25331 × Kp)^{2/3} (Formula 2)

(In Formula 2, p(O₂) represents an oxygen partial pressure; Kp represents the water dissociation equilibrium constant; and the pressure unit is Pa.)

Moreover, the manufacturing method is preferable in the case where a raw material of lead, for example, a raw material of lead zirconate titanate is included as the raw material of the ceramic layer, and the case where a multilayer ceramic device in which the ceramic layer has a thickness of 5 times to 200 times larger than the thickness of the interlayer electrode layer, or a multilayer ceramic device with a volume of 20 mm³ or more is manufactured. In particular, the manufacturing method is preferable in the case where a multilayer piezoelectric device is manufactured.

In the method of manufacturing a multilayer ceramic device according to the invention, 7 mol% to 50 mol% of water vapor is included in the atmospheric gas to adjust the oxygen partial pressure within a range shown in Formula 1, so the oxidation of copper metal and the occurrence of cracks can be prevented. Moreover, residual carbon can be reduced, and the melting of the internal electrode layer can be prevented. Therefore, a large multilayer ceramic device in which the thickness of the ceramic layer is 5 times to 200 times larger than the thickness of the internal electrode layer, or its volume is 20 mm³ or more can be manufactured, and superior properties can be obtained.

In particular, when no hydrogen is mixed with the atmospheric gas, or when the oxygen partial pressure is within a range shown in Formula 2, residual carbon can be further reduced, and the reduction of lead in the ceramic precursor layer can be prevented.

Other and further objects, features and advantages of the invention will appear more fully from the following description.

### BRIEF DESCRIPTION OF THE DRAWINGS

FIG. 1 is a flow chart showing a method of manufacturing a multilayer ceramic device according to an embodiment of the invention;
FIG. 2 is a sectional view of an example of a multilayer ceramic device manufactured by the manufacturing method shown in FIG. 1; and
FIG. 3 is a plot showing an oxygen partial pressure in a degreasing process in each example.

### DETAILED DESCRIPTION OF THE PREFERRED EMBODIMENTS

A preferred embodiment will be described in detail below referring to the accompanying drawings.

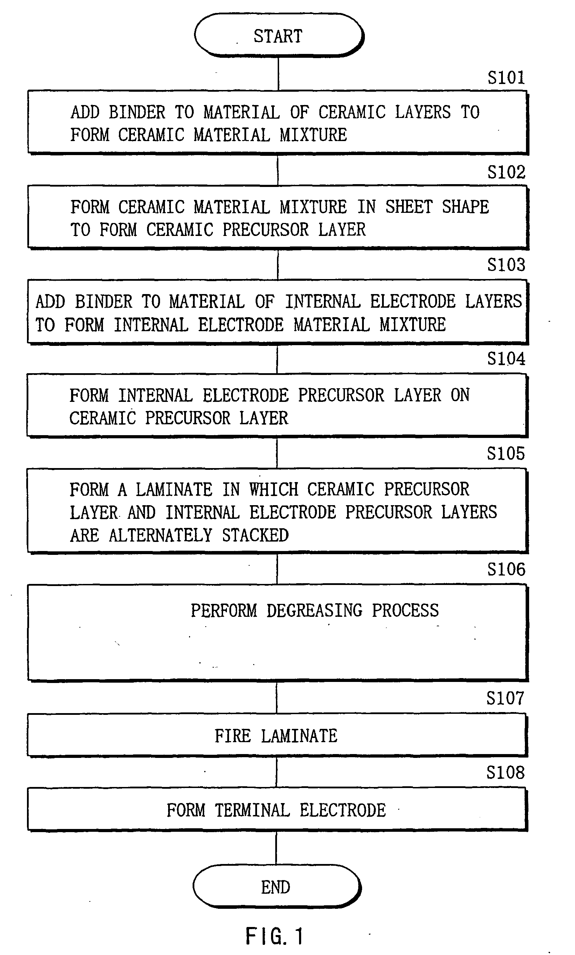

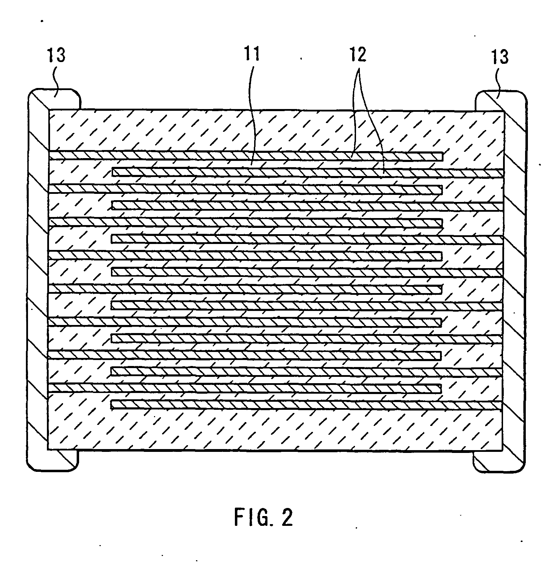

FIG. 1 shows steps in a method of manufacturing a multilayer ceramic device according to an embodiment of the invention. In the embodiment, for example, the case where a ceramic containing a complex oxide with a perovskite structure which includes lead such as lead zirconate titanate is used to manufacture a multilayer ceramic device in which ceramic layers 11 and internal electrode layers 12 are alternately stacked as shown in FIG.2 is described in detail.

At first, after a raw material of the ceramic layers 11 is prepared, and the raw material is weighed according to a target composition, a binder is added to the raw material to form a ceramic material mixture (step S101). As the raw material of the ceramic layers 11, for example, oxides including an element constituting the ceramic layers 11 or compounds such as carbonates, oxalates or hydroxides which can become oxides including the element by firing are used. For example, in the case where the ceramic layers 11 including lead zirconate titanate is formed, as materials of lead (Pb), titanium (Ti) and zirconium (Zr), lead oxide (PbO), titanium oxide (TiO₂₎ and zirconium oxide (ZrO₂) which include Pb, Ti and Zr, respectively, or compounds which can become the oxides by firing are prepared.

Next, the ceramic material mixture is formed in a sheet shape to form a ceramic precursor layer (step S102).

Moreover, as a raw material of the internal electrode layers 12, copper metal is prepared, and a binder is added to the raw material to form an internal electrode material mixture (step S103). As the raw material of the internal electrode layers 12, only copper metal can be used, or a mixture of copper metal and any other material can be used. As the other material, for example, copper oxide or an organic copper compound which becomes copper metal after firing, metal except for copper metal, or a metal oxide or an organic metal compound which becomes the metal after firing is used. Further, an additive such as a dispersant, a plasticizer, a dielectric material or an insulating material may be added to the internal electrode material mixture.

Next, for example, the internal electrode material mixture is screen-printed on the ceramic precursor layer to form an internal electrode precursor layer (step S104). A plurality of ceramic precursor layers on which the internal electrode precursor layer is formed are stacked to form a laminate in which the ceramic precursor layers and the internal electrode precursor layers are alternately stacked (step S105).

After that, the laminate is heated to perform a degreasing process for decomposing and removing the binder (step S106). The degreasing process is performed at 550°C to 600°C in an oxygen partial pressure atmosphere according to Formula 1 through using an atmospheric gas which includes an inert gas such as nitrogen (N₂) or argon (Ar) and 7 mol% to 50 mol% of water vapor, and, if necessary, hydrogen.
(Formula 1)

Kp² × 10¹⁵ ≦ p(O₂) ≦ (25331 × Kp)^{2/3}

(In Formula 1, p(O₂) represents an oxygen partial pressure, and Kp represents the water dissociation equilibrium constant. The pressure unit is Pa.)

As shown in Formula 3, the water vapor has a function of reacting with hydrocarbon or carbon which is a residual carbon component to accelerate the decomposition and removal of residual carbon.
(Formula 3)

CₘHₙ+mH₂O→mCO+{(n+2m)/2}H₂

C+H₂O→CO+H₂

(In Formula 3, m and n are positive integers.)

The amount of water vapor is 7 mol% or more, because when the amount is less than 7 mol%, the binder is not sufficiently decomposed and removed, thereby the residual carbon increases, and in particular, when the number of the ceramic layers 11 or the size of the ceramic layers 11 is large, the amount of residual carbon in the interior of the laminate increases. Moreover, the amount of water vapor is 50 mol% or less, because when the amount is larger than 50 mol%, copper metal included in the internal electrode precursor layers is easily converted to copper (I) oxide (Cu₂O), and copper (I) oxide can diffuse into the ceramic layers 11 at 680°C or more to cause deterioration in properties.

The water vapor has functions of producing oxygen by dissociation equilibrium shown in Formulas 4 and 5, and preventing a change in oxygen partial pressure, even if the concentration of hydrogen increases.
(Formula 4)

H₂O⇔H₂+(1/2)O₂

(Formula 5)

Kp = {p(O₂)^{1/2} × p(H₂)}/p(H₂O)

(In Formula 5, Kp represents the water dissociation equilibrium constant; p(O₂ represents an oxygen partial pressure; p(H₂) represents a hydrogen partial pressure; and p(H₂O) represents a water vapor partial pressure.)

In other words, the oxygen partial pressure in the degreasing process is adjusted within an extremely low range through the use of the water dissociation equilibrium. Thus, the oxygen partial pressure is adjusted through the use of the water dissociation equilibrium, because when the concentration of oxygen is high, copper metal included in the raw material of the internal electrode layer 12 is oxidized to expand, thereby to cause cracks, and it is extremely difficult to control the oxygen partial pressure at a low level through using oxygen as an atmospheric gas.

At this time, when hydrogen is used as an atmospheric gas, by the law of mass action, in Formula 4, a reaction of not dissociating water progresses, thereby the oxygen partial pressure declines, so in order to increase the oxygen partial pressure as high as possible, it is preferable not to use hydrogen. In the case where hydrogen is not used, hydrogen in the atmospheric gas is produced only by the dissociation of water vapor, so a formula p(H₂)=2×p(O₂) is derived from Formula 4. Therefore, Formula 6 is derived from Formula 5.
(Formula 6)

Kp = 2p(O₂)^{3/2}/p(H₂O)

p(O₂)^{3/2} = 0.5 × p(H₂O) × Kp

Thus, as described above, when the maximum amount of water vapor is 50 mol%, p(H₂O) at this time is 0.5 × 101325 (Pa), so the maximum value P(O₂)ₘₐₓ of the oxygen partial pressure in the case where hydrogen is not used is as shown in Formula 7, thereby the upper limit of Formula 1 is derived.
(Formula 7)

p(O₂)^{3/2}ₘₐₓ = 0.5 × 0.5 × 101325 × Kp = 25331 × Kp

p(O₂)ₘₐₓ = (25331 × Kp)^{2/3}

(In Formula 7, the pressure unit is Pa.)

Moreover, the oxygen partial pressure is more preferably within a range shown in Formula 2. It is because when the oxygen partial pressure is low, lead included in the ceramic precursor layer is reduced, thereby lead metal is easily produced, and as a result, the properties of the ceramic material can decline, or lead metal may react with copper metal included in the internal electrode precursor layer to be melted or cut.
(Formula 2)

Kp² × 10¹⁶ ≦ p(O₂) ≦ (25331 × Kp)^{2/3}

(In Formula 2, p(O₂) represents an oxygen partial pressure, and Kp represents the water dissociation equilibrium constant. The pressure unit is Pa.)

Further, hydrogen also has a function of removing residual carbon, so hydrogen can be used together with water vapor as the atmospheric gas. However, when the amount of hydrogen is large, the oxygen partial pressure may decline to increase residual carbon, or lead included in the ceramic precursor layer may be easily reduced, so it is preferable that hydrogen is not used.

The temperature in the degreasing process is not higher than 600°C, because when the temperature exceeds 600°C, a lead-based ceramic material starts to be sintered, so the lead-based ceramic material is densified to block a ventilation path, and thereby to interfere with the decomposition and volatilization of the binder.

After performing the degreasing process, the laminate is fired to form a sintered laminate in which the ceramic layers 11 and the internal electrode layers 12 are alternately stacked (step S107). The firing temperature is higher than the temperature in the degreasing process, and less than the melting point of copper metal, 1083°C, and the firing temperature is preferably 1050°C or less, and more preferably 1000°C or less. In a firing atmosphere, the oxygen partial pressure is controlled so as not to oxidize copper metal included in the internal electrode precursor layer and not to reduce lead included in the ceramic precursor layer.

After firing, an end surface of the sintered laminate is polished by, for example, barreling, sandblasting or the like, and a terminal electrode 13 is formed through sputtering metal such as gold. Alternatively, metal such as gold or an oxide or an organic metal compound which becomes the metal after firing is mixed with a binder to form a terminal electrode material mixture, and the terminal electrode material mixture is printed or transferred to be baked, thereby the terminal electrode 13 is formed (step S108). Thereby, the multilayer ceramic device can be obtained.

Thus, in the embodiment, the atmospheric gas including 7 mol% to 50 mol% of water vapor is used, and the degreasing process is performed in an oxygen partial pressure atmosphere of p(O₂)≦ (25331 × Kp)^{2/3} (pressure unit: Pa), so the oxidization of copper metal, the occurrence of cracks and the diffusion of copper into the ceramic layers 11 can be prevented. Moreover, residual carbon can be reduced, and the reduction of lead in the ceramic layers 11 and the melting of the internal electrode layers 12 can be prevented.

In particular, in the embodiment, in the case of manufacturing a large multilayer ceramic device in which the thickness of the ceramic layer 11 is 5 times to 200 times larger than the thickness of the internal electrode layer 12, or the volume of the multilayer ceramic device is 20 mm³ or more, or a multilayer piezoelectric device which is desired to have such a large size, a large effect can be obtained, and superior properties can be obtained. In addition, the thickness of the ceramic layer 11 means the thickness of one ceramic layer 11 sandwiched between the internal electrode layers 12, and the thickness of the internal electrode layer 12 means the thickness of one internal electrode layer 12 sandwiched between the ceramic layers 11.

Moreover, when no hydrogen is mixed with the atmospheric gas in the degreasing process, or when the oxygen partial pressure is within a range of Kp² × 10¹⁶≦ p(O₂) (pressure unit: Pa), residual carbon can be further reduced, and in the degreasing process, the reduction of lead included in the ceramic precursor layer can be prevented.

### [Examples]

Next, specific examples will be described below.
(Examples 1 through 8, wherein Examples 1, 2 and 6 are embodiments of the present invention and Examples 3-5, 7 and 8 are Comparative Examples)

A sintered laminate including the ceramic layers 11 which contained a lead-based perovskite complex oxide including lead zirconate titanate and the internal electrode layers 12 which contained copper metal was formed as each of Examples 1 through 8. At first, after the raw material of the ceramic layers 11 was prepared, and weighed, a methacrylate-based binder was added to the raw material of the ceramic layers 11 to form a mixture (step S101), and then the mixture was formed in a sheet shape to form the ceramic precursor layer (step S102).

As the raw material of the internal electrode layer 12, copper metal was prepared, and an ethyl cellulose-based binder was added to copper metal to form a mixture (step S103), and the mixture was screen-printed on the ceramic precursor layer to form the internal electrode precursor layer (step S104). Next, after 360 ceramic precursor layers on which the internal electrode precursor layer was formed were stacked, and they were pressure-bonded, they were cut so as to have a 8 mm × 8 mm cross section to which the normal is in a stacking direction (step S105).

Next, the laminate was inserted into a tubular furnace made of aluminum oxide to perform a degreasing process by heating (step S106). As the heating conditions, after the laminate was heated at a temperature rising rate of 3.3°C/min from a room temperature to 200°C, a temperature rising rate of 0.3°C/min from 200°C to 400°C, and a temperature rising rate of 1.0°C/min from 400°C to 550°C, and the laminate was kept at 550°C for 48 hours, the laminate was cooled at a temperature decreasing rate of 3.3°C/min. An atmospheric gas formed through bubbling nitrogen or a mixture gas of nitrogen and hydrogen into water of which the temperature was maintained at a predetermined temperature to saturate water vapor was,inserted into the furnace.

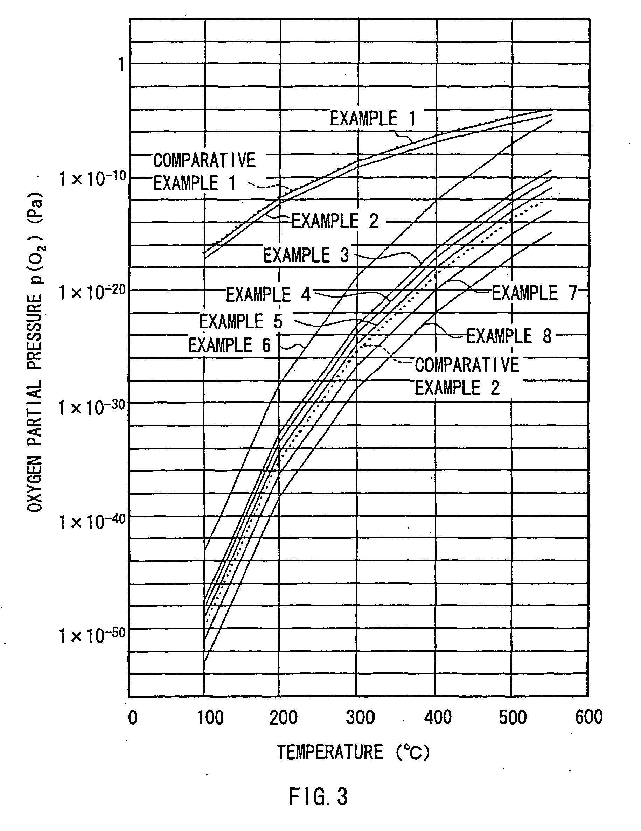

At that time, in Examples 1 through 8, the amount of water vapor and the amount of hydrogen were changed as shown in Table 1, thereby the oxygen partial pressure in the furnace was adjusted as shown in Table 1. The amount of water vapor was adjusted through changing the temperature of water. The oxygen partial pressure shown in Table 1 (the pressure unit: Pa) was an α value in the case where the oxygen partial pressure was represented by Kp² × α, and a β value in the case of the oxygen partial pressure was represented by (β × Kp)^{2/3}. Moreover, FIG. 3 shows the oxygen partial pressure in each example.

The appearance of the degreased laminate was visually observed to check the presence or the absence of cracks. Moreover, the amounts of residual carbon in an internal portion and a peripheral portion of the laminate were analyzed. The peripheral portion indicated a region within 1/4 of a side, that is, 2 mm inside from the periphery of a cross section to which the normal was in a stacking direction, and the internal portion indicated a region inside the peripheral portion. As a result, no cracks occurred in all of Examples 1 through 8, and the amount of residual carbon was sufficiently low. However, in Example 8, lead was reduced, thereby lead metal was slightly observed in the ceramic precursor layer. The obtained results are shown in Table 1.

After that, the degreased laminate was fired at 950°C for two hours in an oxygen partial pressure atmosphere in which copper metal was not oxidized and lead was not reduced to obtain a sintered laminate. When the firing state of the obtained sintered laminate was observed, there was no problem in Examples 1 through 7; however, in Example 8, the internal electrode layers 12 were partially formed in a spherical shape. The results are shown in Table 1.

As Comparative Examples 1 and 2 relative to Examples 1 through 8, sintered laminates were formed as in the case of Examples 1 through 8, except that the amount of water vapor and the amount of hydrogen in the atmospheric gas used in the degreasing process were changed as shown in Table 1, and the oxygen partial pressure in the furnace was changed as shown in Table 1. Moreover, as Comparative Examples 3 and 4 relative to Examples 1 through 8, laminates were formed, and the degreasing process was performed as in the case of Examples 1 through 8, except that the degreasing process was performed in air, or at an oxygen partial pressure of 1 Pa through using oxygen as an atmospheric gas. As in the case of Examples 1 through 8, the degreased laminates of Comparative Examples 1 through 4 and the sintered laminate of Comparative Examples 1 through 4 were observed. The results are shown in Table 1. After degreasing, cracks occurred in the laminates of Comparative Examples 3 and 4, so the laminates were not fired.

**[Table 1]**

| | DEGREASING CONDITIONS | | | | AFTER DEGREASING | | | | AFTER FIRING |
|---|---|---|---|---|---|---|---|---|---|
| | ATMOSPHERIC GAS | | OXYGEN PARTIAL PRESSURE (Pa) | | AMOUNT OF RESIDUAL CARBON (ppm) | | CRACKS | PROBLEM | PROBLEM |
| | WATER VAPOR (mol%) | HYDROGEN (ppm) | Kp₂×α (β×Kp)^{2/3} | | INTERNAL PORTION | PERIPHERAL PORTION | | | |
| | | | α | β | | | | | |
| EXAMPLE 1 | 47 | 0 | > 10¹⁶ | 2.4×10⁴ | 130 | 120 | NOT OCCURRED | - | - |
| EXAMPLE 2 | 7 | 0 | >10¹⁶ | 4×10³ | 140 | 130 | NOT OCCURRED | - | - |
| EXAMPLE 3 | 47 | 1 | 10¹¹ | <10⁻³ | 110 | 100 | NOT OCCURRED | - | - |
| EXAMPLE 4 | 20 | 1 | 10¹⁰ | <10⁻⁴ | 140 | 120 | NOT OCCURRED | - | - |
| EXAMPLE 5 | 7 | 1 | 10⁹ | < 10⁻⁶ | 180 | 150 | NOT OCCURRED | - | - |
| EXAMPLE 6 | 7 | 0.001 | 10¹⁵ | <4×10³ | 160 | 140 | NOT OCCURRED | - | - |
| EXAMPLE 7 | 7 | 10 | 10⁷ | < 10⁻⁹ | 150 | 140 | NOT OCCURRED | - | - |
| EXAMPLE 8 | 7 | 100 | 10⁵ | <10⁻¹² | 170 | 160 | NOT OCCURRED | LEAD WAS SLIGHTLY REDUCED | PAPTIALY FORMED IN SPHERICAL SHAPE |
| COMPARATIVE EXAMPLE 1 | 57 | 0 | > 10¹⁶ | 3.0×10⁴ | 120 | 100 | NOT OCCURRED | - | EXCESSIVE DIFFUSION OF COPPER |
| COMPARATIVE EXAMPLE 2 | 3 | 1 | 10⁹ | <10⁻⁷ | 1130 | 380 | NOT OCCURRED | AMOUNT OF RESIDUAL CARBON WAS LARGE | MELTING OF COPPER |
| COMPARATIVE EXAMPLE 3 | IN AIR | | | | 100 | 100 | OCCURRED | CRACKS OCCURED | NOT FIRED |
| COMPARATIVE EXAMPLE 4 | OXYGEN PARTIAL PRESSURE OF 1 Pa | | | | - | - | OCCURRED | CRACKS OCCURED | NOT FIRED |

As shown in Table 1, in Examples 1 through 8, no crack was observed in the degreased laminates, and the amount of residual carbon was sufficiently low. Moreover, in the sintered laminates in Examples 1 through 8, the diffusion of copper into the ceramic layer 11 or the melting of copper out of the internal electrode layer 12 was not observed.

On the other hand, in Comparative Example 1 in which the amount of water vapor was larger than 50 mol%, no crack occurred in the degreased laminate; however, excessive diffusion of copper into the ceramic layer 11 was observed in the sintered laminate. Moreover, in Comparative Example 2 in which the amount of water vapor was less than 7 mol%, the amount of residual carbon in the degreased laminate was large, and the melting of copper out of the internal electrode layer 12 was observed in the sintered laminate. Further, in Comparative Examples 3 and 4 in which the oxygen partial pressure was higher, cracks occurred in the degreased laminate.

In other words, it was found out that in the case where an atmospheric gas including 7 mol% to 50 mol% of water vapor was used, and the degreasing process was performed in an oxygen partial pressure atmosphere of p(O₂) ≦ (25331 × Kp)^{2/3} (pressure unit: Pa), even if the number of layers was as many as 360 layers, the oxidation of copper metal included in the internal electrode precursor layer could be prevented, thereby the occurrence of cracks could be prevented, and residual carbon could be reduced, and the melting of an internal electrode could be prevented.

Moreover, it was obvious from a comparison between Examples 2 and 5 through 8 that in Examples 2, and 5 through 7 in which the concentration of hydrogen in the atmospheric gas was 0 molppm to 10 molppm, no problem was observed after degreasing or firing; however, in Example 8 in which the concentration of hydrogen in the atmospheric gas was 100molppm, and the oxygen partial pressure was less than Kp² × 10⁶ Pa, the reduction of lead was observed in the ceramic precursor layer after degreasing, and thereby the internal electrode layer 12 was slightly formed in a spherical shape after firing.

In other words, it was found out that when no hydrogen or 10 molppm or less of hydrogen was mixed with the atmospheric gas, or when the oxygen partial pressure was Kp² × 10⁶ Pa or more, the reduction of lead included in the ceramic precursor layer could be prevented.

Although the invention is described referring to the embodiment and the examples, the invention is not limited to the embodiment and the examples, and can be variously modified. For example, in the embodiment and the examples, the case where the lead-based perovskite complex oxide including lead zirconate titanate is used is described; however, the invention can be applied to the case where any other lead-based perovskite complex oxide including lead niobate magnesate or the like is used. Moreover, in addition to lead zirconate titanate, any other component such as lead niobate or lead zincate may be included. Further, calcium (Ca), strontium (Sr), barium (Ba) or the like may substitute for a part of lead, and various sub-components may be added.

Moreover, in the embodiment and the examples, the case where the lead-based perovskite complex oxide is used is described; however, the invention can be applied to the case where the ceramic layer 11 is formed of any other ceramic material not including lead. As the ceramic material, for example, a ceramic material including barium titanate, a bismuth layer structured oxide, sodium bismuth titanate or potassium bismuth titanate is cited.

The invention can be widely applied to the fields of multilayer capacitors, multilayer piezoelectric devices and the like, and the invention is specifically suitable for manufacturing multilayer actuators.

## Claims

1. A method of manufacturing a multilayer ceramic device, comprising the step of:
degreasing a laminate for removing a binder by heating in which ceramic precursor layers including a raw material of a ceramic layer and internal electrode precursor layers including copper metal as a raw material of an internal electrode layer are alternately stacked,
wherein an atmospheric gas including an inert gas and 7 mol% to 50 mol% of water vapor is used to perform the step in an oxygen partial pressure atmosphere according to the relation :
Kp² × 10¹⁵ ≦ p(O₂) ≦ (25331 × Kp)^{2/3} (Formula 1)
wherein p(O₂) represents an oxygen partial pressure; Kp represents the water dissociation equilibrium constant; and the pressure unit is Pa, and wherein the step is performed at 550°C to 600°C.

2. A method of manufacturing a multilayer ceramic device according to claim 1, wherein
hydrogen is not mixed with the atmospheric gas.

3. A method of manufacturing a multilayer ceramic device according to any one of claims 1 through 2, wherein
the step is performed in an oxygen partial pressure atmosphere according to the relation:
Kp² × 10¹⁶ < p(O₂) ≦ (25331 × Kp)^{2/3} (Formula 2)
wherein p(O₂) represents an oxygen partial pressure; Kp represents the water dissociation equilibrium constant, and the pressure unit is Pa.

4. A method of manufacturing a multilayer ceramic device according to any one of claims 1 through 3, wherein
the ceramic precursor layers include a raw material of lead as the raw material of the ceramic layer.

5. A method of manufacturing a multilayer ceramic device according to claim 4, wherein
the ceramic precursor layers include a raw material of lead zirconate titanate as the raw material of the ceramic layer.

6. A method of manufacturing a multilayer ceramic device,
wherein a multilayer ceramic device in which a ceramic layer has a thickness of 5 times to 200 times larger than the thickness of the internal electrode layer is manufactured through a method according to any one of claims 1 through 5.

7. A method of manufacturing a multilayer ceramic device,
wherein a multilayer ceramic device with a volume of 20 mm³ or more is manufactured through a method according to any one of claims 1 through 6.

8. A method of manufacturing a multilayer ceramic device,
wherein a multilayer piezoelectric device is manufactured through a method according to any one of claims 1 through 7.

## Patentansprüche

1. Verfahren zur Herstellung eines keramischen Mehrschichtbauelements, umfassend den Schritt:
Entfetten eines Laminats zur Entfernung eines Bindemittels durch Erhitzen, wobei Keramikvorläufer-Schichten, enthaltend ein Rohmaterial einer keramischen Schicht, und interne Elektrodenvorläufer-Schichten, enthaltend Kupfermetall als ein Rohmaterial einer internen Elektrodenschicht, abwechselnd gestapelt sind,
worin ein Atmosphärengas, enthaltend ein Inertgas und 7 Mol-% bis 50 Mol-% Wasserdampf, verwendet wird, um den Schritt in einer Atmosphäre mit Sauerstoffpartialdruck gemäß der Beziehung:
Kp² × 10¹⁵ ≤ p(O₂) ≤ (25331 × Kp)^{2/3} (Formel 1),
wobei p(O₂) den Sauerstoffpartialdruck darstellt; Kp die Wasserdissoziations-Gleichgewichtskonstante darstellt; und die Druckeinheit Pa ist; durchzuführen, und wobei der Schritt bei 550°C bis 600°C durchgeführt wird.

2. Verfahren zur Herstellung eines keramischen Mehrschichtbauelements nach Anspruch 1, wobei
Wasserstoff nicht mit dem atmosphärischen Gas gemischt wird.

3. Verfahren zur Herstellung eines keramischen Mehrschichtbauelements nach irgendeinem der Ansprüche 1 bis 2, wobei
der Schritt in einer Atmosphäre mit Sauerstoffpartialdruck gemäß der Beziehung:
Kp² × 10¹⁶ < p(O₂) ≤ (25331 × Kp)^{2/3} (Formel 2),
wobei p(O₂) den Sauerstoffpartialdruck darstellt; Kp die Wasserdissoziations-Gleichgewichtskonstante darstellt; und die Druckeinheit Pa ist; durchgeführt wird.

4. Verfahren zur Herstellung eines keramischen Mehrschichtbauelements nach irgendeinem der Ansprüche 1 bis 3, wobei
die Keramikvorläufer-Schichten ein Bleirohmaterial als das Rohmaterial der Keramikschicht enthalten.

5. Verfahren zur Herstellung eines keramischen Mehrschichtbauelements nach Anspruch 4, wobei
die Keramikvorläufer-Schichten ein Rohmaterial aus Bleizirkonattitanat als das Rohmaterial der Keramikschicht enthalten.

6. Verfahren zur Herstellung eines keramischen Mehrschichtbauelements,
wobei ein keramisches Mehrschichtbauelement, in der eine Keramikschicht eine 5mal bis 200mal größere Dicke als die Dicke der internen Elektrodenschicht aufweist, durch ein Verfahren nach irgendeinem der Ansprüche 1 bis 5 hergestellt wird.

7. Verfahren zur Herstellung eines keramischen Mehrschichtbauelements,
wobei ein keramisches Mehrschichtbauelement mit einem Volumen von 20 mm³ oder mehr durch ein Verfahren nach irgendeinem der Ansprüche 1 bis 6 hergestellt wird.

8. Verfahren zur Herstellung eines keramischen Mehrschichtbauelements,
worin ein mehrschichtpiezoelektrisches Bauelement durch ein Verfahren nach irgendeinem der Ansprüche 1 bis 7 hergestellt wird.

## Revendications

1. Procédé pour fabriquer un dispositif multicouche en céramique, comprenant l'étape qui consiste à :
dégraisser un stratifié pour éliminer un liant par chauffage, dans lequel des couches précurseurs en céramique comprenant une matière première de couche de céramique, et des couches précurseurs d'électrode interne comprenant du métal cuivre en tant que matière première d'une couche d'électrode interne, sont empilées en alternance,
un gaz atmosphérique contenant un gaz inerte et 7 % à 50 % en moles de vapeur d'eau étant utilisé pour réaliser cette étape dans une atmosphère à pression partielle d'oxygène, suivant la relation :
Kp² × 10¹⁵ ≤ p(O₂) ≤ (25331 × Kp)^{2/3} (formule 1)
dans laquelle p(O₂) représente une pression partielle d'oxygène ; Kp représente la constante d'équilibre de dissociation de l'eau ; et l'unité de pression est le Pa, et l'étape étant exécutée à 550°C à 600°C.

2. Procédé pour fabriquer un dispositif multicouche en céramique selon la revendication 1, dans lequel de l'hydrogène n'est pas mélangé au gaz atmosphérique.

3. Procédé pour fabriquer un dispositif multicouche en céramique selon l'une quelconque des revendications 1 et 2, dans lequel l'étape est exécutée dans une atmosphère à pression partielle d'oxygène suivant la relation :
Kp² × 10¹⁶ < p(O₂) ≤ (25331 × Kp)^{2/3} (formule 2)
dans laquelle p(O₂) représente une pression partielle d'oxygène ; Kp représente la constante d'équilibre de dissociation de l'eau ; et l'unité de pression est le Pa.

4. Procédé pour fabriquer un dispositif multicouche en céramique selon l'une quelconque des revendications 1 à 3, selon lequel les couches précurseurs en céramique comprennent une matière première constituée de plomb comme matière première de la couche de céramique.

5. Procédé pour fabriquer un dispositif multicouche en céramique selon la revendication 4, dans lequel les couches précurseurs en céramique comprennent une matière première constituée de zirconate titanate de plomb en tant que matière première de la couche de céramique.

6. Procédé pour fabriquer un dispositif multicouche en céramique, dans lequel un dispositif multicouche en céramique dans lequel une couche de céramique a une épaisseur 5 à 200 fois supérieure à l'épaisseur de la couche d'électrode interne est fabriqué à l'aide d'un procédé selon l'une quelconque des revendications 1 à 5.

7. Procédé pour fabriquer un dispositif multicouche en céramique, dans lequel un dispositif multicouche en céramique d'un volume de 20 mm³ ou plus est fabriqué à l'aide d'un procédé selon l'une quelconque des revendications 1 à 6.

8. Procédé pour fabriquer un dispositif multicouche en céramique, dans lequel un dispositif piézoélectrique multicouche est fabriqué à l'aide d'un procédé selon l'une quelconque des revendications 1 à 7.
